# EUROPEAN PATENT SPECIFICATION

(11) **EP 1 892 724 B1**
(45) Date of publication and mention of the grant of the patent: **09.12.2009**
(21) Application number: 06119440.3
(22) Date of filing: 24.08.2006
(51) Int. Cl.: G11C 16/08, G11C 8/08

(54) **A memory device with row selector comprising series connected medium voltage transistors**
Speichervorrichtung mit einem Zeilenselektor mit in Serie geschalteten Mittelspannungstransistoren
Dispositif de mémoire avec sélecteur des rangées ayant des transistors à tension moyenne reliés en série

(43) Date of publication of application: 27.02.2008
(73) Proprietor: STMicroelectronics S.r.l., 20041 Agrate Brianza (Milano) (IT)
(72) Inventor: Micheloni, Rino, 22078 Turate (CO) (IT); Campardo, Giovanni, 24128 Bergamo (BG) (IT)
(74) Representative: Bartle, Robin Jonathan

(56) References cited:
- US-A- 4 710 900
- US-A- 5 740 107
- US-B1- 6 181 606

## Description

The present invention generally relates to the field of semiconductor memory devices and, more particularly, to the field of non-volatile memory devices. Specifically, the invention relates to non-volatile memory devices that are electrically programmable.

United States patent 4710900 (Higuchi) whereon the preamble of claim 1 is based describes a non-volatile semiconductor device having an improved write voltage application circuit of the type having a plurality of non-volatile memory elements each coupled to a row line and a column line. A write voltage application circuit is provided for each row line for operatively applying a regulated write current to the row line in a write state. The write voltage application circuit includes a P-channel MIS transistor which is adapted to take a conductive state of a large resistance at least in a write state, for regulating the amount of the write current.

Non-volatile memory devices are commonly used in several applications when the data stored in the memory device need to be preserved even in absence of power supply. Within the class of non-volatile memory devices, electrically programmable (and erasable) memories have become very popular in applications in which the data to be stored are not immutable, being instead necessary from time to time to store new data, or to update the data already stored.

Typically, the memory device includes an arrangement of memory cells, disposed for example in rows and columns, so as to form a matrix.

Flash memory devices are a particular type of electrically programmable memory, in which each memory cell is formed by a floating gate MOS transistor. Each memory cell has a threshold voltage (which depends on the amount of electric charge stored in the corresponding floating gate), which can be programmed to different levels representing corresponding logical values.

Depending on the way the memory cells in the matrix are interconnected, two classes of flash memory devices can be identified: those having a so-called NOR architecture, or NOR memories, and those having a so-called NAND architecture, shortly referred to as NAND memories. Roughly speaking, in the NOR architecture the memory cells of a same matrix column are connected in parallel to a same bit line, whereas in the NAND architecture groups of memory cells of a same matrix column are serially interconnected so as to form respective strings, which strings are then connected in parallel to each other to a same bit line.

Compared to NOR memories, NAND memories are more compact (a lower number of contacts in the matrix area are required), and they are also better suited for applications such as file storage. However, NAND memories require more complex circuits for performing reading and programming operations with respect those usually required for reading and programming NOR memories. In addition, the thickness of the gate oxide layer of a memory cell of a typical NOR memory is equal to about 90 Angstrom, while for a typical NAND memory it is equal to about 100 Angstrom.

In order to retrieve and/or store information, flash memory devices include a decoding system that is adapted to decode an addressing code identifying a memory location, corresponding to a group of memory cells. In particular, the decoding system includes a row selector for selecting a corresponding word line and a column selector for selecting a corresponding set of bit lines.

Both the row selector and the column selector must be able to apply operative voltages of relatively high value to the selected memory cells, e.g. during program and erase operations. These voltages (for example, ranging from -6 Volts to 12 Volts) are higher than a supply voltage Vcc of the memory device, which may be of 3 Volts, in absolute value. For example, in single supply voltage memory devices, the high voltages necessary for, e.g., programming and erasing the memory cells are generated inside the memory device from the supply voltage Vcc, by means of suitable circuits (such as, charge pumps).

Considering for example the row selector of a NOR memory, a typical situation is the biasing of the selected word line associated with the memory cells to be programmed; in this case, the selected word line should for example be biased to a program voltage of about 12 Volts.

Therefore, only the standard circuitry of the memory device (e.g., the logic circuitry) can be implemented with "low voltage transistors"; for the purpose of the present description, by "low voltage transistor" there is meant a transistor designed in such a way to be able to sustain, across its terminals, voltage differences that are up-limited (in absolute value) by a predetermined maximum voltage difference ΔV1 equal to the supply voltage Vcc. Indeed, the relatively low voltages that are experienced by these transistors allow their correct functioning (without causing breaking thereof) in any condition. For example, low voltage MOS transistors are designed in such a way to guarantee that no gate oxide breaking or undesired junctions breakdown occur when low voltage differences are applied to their terminals (for example, between the gate and source terminals).

Conversely, the row selector is a circuit that usually needs to be implemented with "high voltage transistors"; for the purpose of the present description, by "high voltage transistor" there is intended a transistor designed in such a way to be able to sustain, across its terminals, voltage differences that are up-limited (in absolute value) by a predetermined maximum voltage difference ΔVh at least equal to the highest (in absolute value) voltage HV that the row selector has to manage (in case of a row selector for a NOR memory, said highest voltage HV is for example equal to 12-13 Volts, while in case of a row selector for a NAND memory, said highest voltage HV may be equal to 20-21 Volts). This ensures that high voltage transistors operate properly (without experiencing any breaking) even when they are subjected to the abovementioned high voltages. For example, high voltage MOS transistors are designed in such a way to ensure that no gate oxide breaking or undesired junctions breakdown occur even when voltages higher than the supply voltage Vcc are applied to their terminals.

High voltage transistors must have a gate oxide layer thicker than that used for low voltage transistors. Indeed, the thicker the gate oxide layer of a transistor, the higher the voltage that can be sustained at its terminals without undesired breaking. For example, the thickness of the gate oxide layer of high voltage transistors used in NOR memories may be equal to 150-160 Angstrom, while the thickness of the gate oxide layer of high voltage transistors used in NAND memories is equal to about 300 Angstrom. Since high voltage transistors occupy more silicon area compared to low voltage transistors, the row decoder is a circuit that occupy a significant area of a chip wherein the memory device is integrated.

Moreover, the use of both low voltage and high voltage transistors increases the number of manufacturing process steps and lithographic masks (for example, for differentiating the oxide thickness of the high and low voltage transistors); this has a detrimental impact on the manufacturing process of the memory device.

In view of the state of the art outlined in the foregoing, the Applicant has faced the problem of how to improve the known solutions for implementing row selectors for memory devices. Particularly, the Applicant has tackled the problem of how to realize a row selector that does not make use of HV transistors.

This and other objects have been attained by means of a memory device as set forth in appended claim 1. Particularly, the memory device includes a memory matrix comprising a plurality of memory cells, arranged according to a plurality of rows and a plurality of columns. The memory device further includes a plurality of word lines; each word line is associated with one respective row of said plurality and is connected to the memory cells of the row; the word lines are grouped into at least one packet. The memory device includes a row selector coupled to the word lines and adapted to selectively biasing them. The row selector includes, for each packet of word lines, a plurality of first paths, wherein each first path is adapted to apply a first biasing voltage to a corresponding word line of the packet depending on an operation to be performed on the memory cells connected to the corresponding word line. Each first path includes at least a first and a second selection transistors series-connected between a first terminal and a second terminal of the first path. The second terminal is coupled to the corresponding word line. The memory device further includes enabling means for commonly providing an enabling voltage to the first terminal of the first paths associated to a selected packet of word lines including a selected word line. The enabling voltage depends on the operation to be performed on the memory cells connected to the selected word line and is adapted to enable the execution of said operation. The memory device further includes selection means for selecting one among said plurality of first paths. the selected first path corresponding to the selected word line. The selection means are adapted to activate the first selection transistor of the selected first path in order to obtain the first biasing voltage from the enabling voltage by a voltage drop introduced by the first selection transistor; said selection means are further adapted to activate the second selection transistor of the selected first path in order to transfer the first biasing voltage provided by the first selection transistor onto the selected word line.

The features and advantages of the invention will be best understood by reading the following detailed description of a non-limitative embodiment thereof, provided merely by way of non-limitative example, to be read in conjunction with the accompanying drawings, wherein:
Figure 1 shows a schematic block diagram of a memory device having a NOR architecture wherein the solution according to an embodiment of the present invention is applicable;
Figure 2 illustrates a generic section of a row selector of the memory device of Figure 1, according to an embodiment of the present invention;
Figure 3 illustrates the biasing voltages applied to the section of the row selector of Figure 2 during a program operation of the memory device, according to an embodiment of the present invention;
Figure 4 illustrates the biasing voltages applied to the section of the row selector of Figure 2 during a read operation of the memory device, according to an embodiment of the present invention;
Figure 5 illustrates the biasing voltages applied to the section of the row selector of Figure 2 during an erase operation of the memory device, according to an embodiment of the present invention;
Figure 6 shows a schematic block diagram of a memory device having a NAND architecture wherein the solution according to a further embodiment of the present invention is applicable;
Figure 7 illustrates a generic section of a row selector of the memory device of Figure 6, according to an embodiment of the present invention; and
Figure 8 illustrates the biasing voltages applied to the section of the row selector of Figure 7 during a program operation of the memory device, according to an embodiment of the present invention.

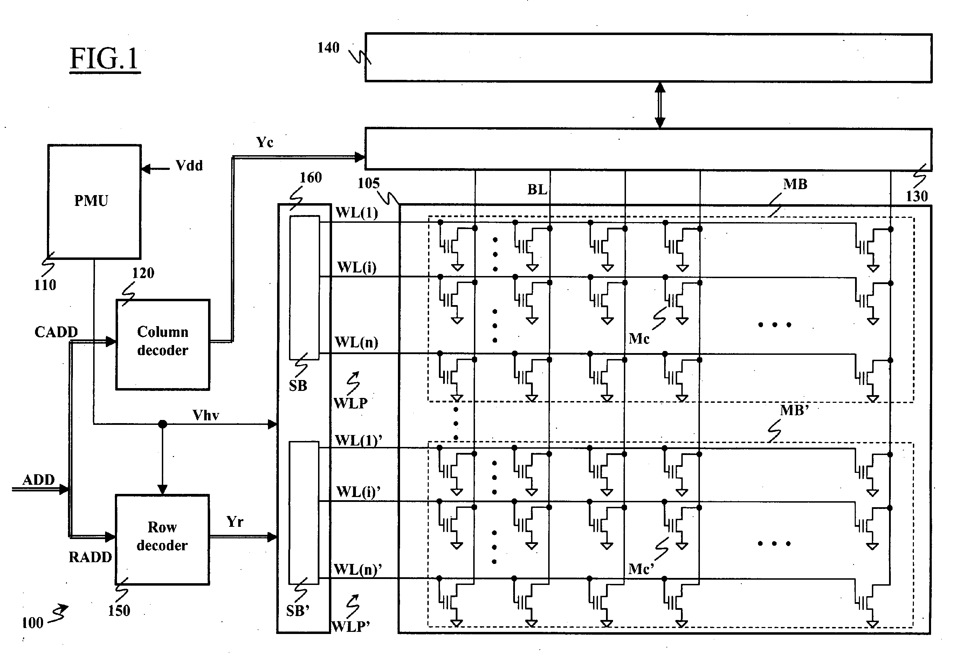

With reference to the drawings, in Figure 1 a non-volatile memory device 100, particularly a flash E²PROM, is illustrated. The memory device 100 includes a matrix 105 of memory cells Mc; typically, each memory cell Mc consists of a floating-gate nMOS transistor. In an erased condition, the memory cell Mc has a low threshold voltage (conventionally associated with a logic value"1"). The memory cell Mc is programmed by injecting electric charges into its floating gate; in the programmed condition, the memory cell Mc has a relatively high threshold voltage (conventionally associated with a logic value "0"). Therefore, when a selected memory cell Mc is biased for reading its content, the memory cell Mc is conductive if erased or non-conductive if programmed.

The memory cells Mc are arranged in rows and columns. The memory device 100 includes a bit line for each column of the matrix 105, and a word line for each row of the matrix. The memory device 100 has a NOR architecture. Particularly, the memory cells Mc of each column have the drain terminals connected to a respective bit line BL, while the memory cells Mc of each row have the gate terminals connected to a respective word line. The source terminal of every memory cell Mc receives a reference voltage GND (or ground voltage). The memory cells Mc are grouped in memory blocks MB; all the memory cells Mc of a memory block MB are erased at the same time. For this purpose, the word lines are grouped in packets WLP of n (for example, 256-1024) word lines, denoted as WL(i), (i=1 to n): the collection of all the memory cells Mc corresponding to the word lines WL(i) of a packet WLP forms a memory block MB. By way of example, in the matrix 105 of Figure 1 two memory blocks are shown, identified with MB and MB', respectively. In the following description, the elements corresponding to the memory block MB' will be discriminated with the addition of an apex "' " *(i.e.,* WL(i) and WL(i)').

The memory device 100 simultaneously reads/programs a word; the bits forming a generic word are stored in memory cells Mc associated with a single word line WL(i) and with a set of bit lines BL, each one for a bit of the word.

The memory device 100 further includes a Power Management Unit (PMU) 110. The PMU 110 provides different operative voltages Vhv that are used for performing the conventional operations (such as read, program, erase and verify) on the memory device 100. The PMU 110 generates the operative voltages Vhv from a supply voltage Vcc (for example equal to 3 Volts) that is received from the outside; the operative voltages Vhv may be higher in absolute value than the supply voltage Vcc, for example, they may range from -6 Volts to 12 Volts. For this purpose, the PMU 110 includes a circuitry (*e.g.,* charge pumps) adapted to generate the operative voltages Vhv from the supply voltage Vcc.

Moreover, the memory device 100 receives an address code ADD for accessing a selected group of memory cells Mc (a memory page) storing a word. The address code ADD consists of a binary codelogical signal formed by a set of bits (such as 8 or 32).

The selection of the desired bit lines BL is carried out by means of a column decoding system including a column decoder 120 and a column selector 130. The column decoder 120 receives a portion of the address code ADD, namely, a column address CADD, and accordingly generates a plurality of column selection signals (denoted as a whole with Yc). The column-selection signals Yc are provided to the column selector 130, which enables a corresponding set of bit lines BL. The column selector 130 connects the selected bit lines BL to a Read/Program (R/P) circuitry 140; the other bit lines BL are instead kept insulated from the R/P circuitry 140. The R/P circuitry 140 includes all the components (*e.g.,* sense amplifiers, comparators, reference current/voltage generators, pulse generators, program load circuits and the like), which are normally required for programming the desired logic values into the selected memory cells Mc and for reading the logic values currently stored therein.

The selection of the desired word line WL(i) is instead carried out by means of a row decoding system including a row decoder 150 and a row selector 160. The row decoder 150 receives a further portion of the address code ADD, namely, a row address RADD, and accordingly generates a plurality of row selection signals (denoted as a whole with Yr). The row selection signals Yr are provided to the row selector 160, which uses them to enable a single word line WL(i) at a time. The row selector 160 has a modular structure, comprising a sub-selector SB for each packet WLP; all the sub-selectors SB receive the same row selection signals Yr. Particularly, the row selector 160 biases the selected word line WL(i) to one of the operative voltages Vhv according to the operation to be performed on the memory device 100, while the other word lines WL(i) are driven to the ground voltage GND.

During a program operation, the selected memory cells Mc that need to be programmed (*i.e.,* the memory cells Mc of the selected word line WL(i)) receive a program voltage PV (for example, 12 Volts) at their gate terminals. For this purpose, the PMU 110 provides a program enabling voltage PEV (for example, 13 Volts) and a program disabling voltage PDV (for example, 7 Volts) to the row selector 160. The program enabling voltage PEV is then provided to the sub-selector SB corresponding to the packet WLP comprising the selected word line WL(i), while the other sub-selectors SB receive instead the program disabling voltage PDV. The sub-selector SB that has received the program enabling voltage PEV biases in turn the selected word line WL(i) at the program voltage PV and the other word lines WL(i) of the packet WLP are biased at the ground voltage GND. Conversely, the remaining sub-selectors SB, *i.e.,* those sub-selectors that have received the program disabling voltage PDV, bias all the word lines of their corresponding packet WLP to the ground voltage GND.

During a read operation, the selected memory cells Mc that need to be read receive a read voltage RV (for example, 5 Volts) at their gate terminals. For this purpose, the PMU 110 provides a read enabling voltage REV (for example, 6 Volts) and a read disabling voltage RDV (for example, 3 Volts) to the row selector 160. In the same way as in the program operation, the read enabling voltage REV is provided to the sub-selector SB corresponding to the packet WLP comprising the selected word line WL(i), while the other sub-selectors SB receive instead the read disabling voltage RDV. The sub-selector SB that has received the read enabling voltage REV biases in turn the selected word line WL(i) at the read voltage RV and the other word lines WL(i) of the packet WLP are biased at the ground voltage GND. Conversely, the remaining sub selectors SB, *i.e.,* those sub-selectors that have received the read disabling voltage RDV, bias all the word lines of their corresponding packet WLP at the ground voltage GND.

During an erase operation, all the memory cells Mc of a selected memory block MB are erased at the same time. The memory cells Mc of the selected memory block MB receive an erase voltage EV (a negative voltage, for example equal to -6 Volts) at their gate terminals. For this purpose, the sub-selector SB biases in turn all the word lines WL(i) of the corresponding packet WLP at the erase voltage EV, while the others sub-selectors SB bias all the word lines of their corresponding packet WLP at the ground voltage GND.

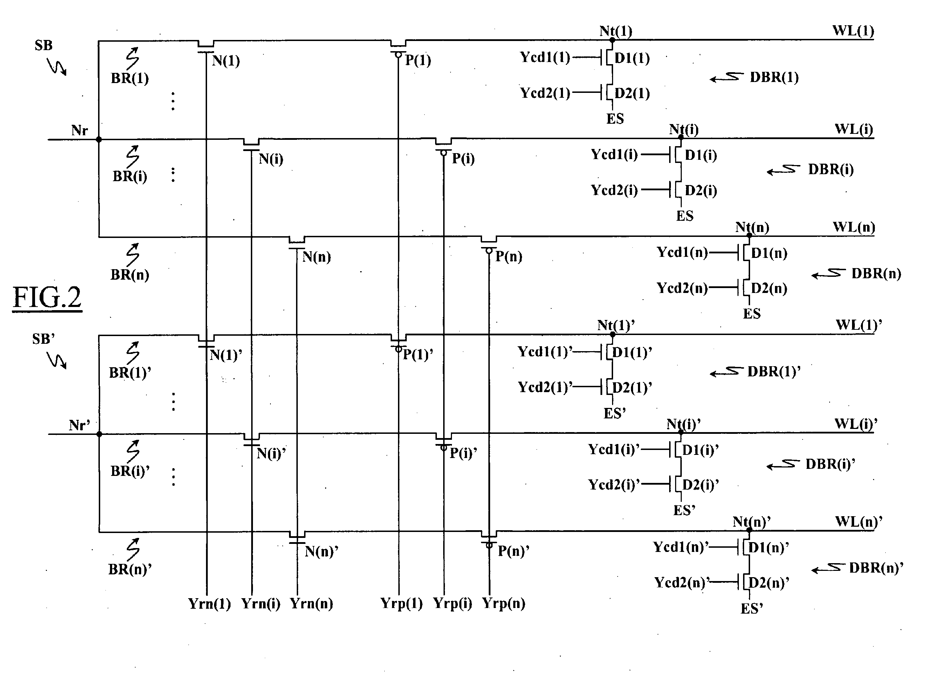

Figure 2 illustrates a circuit diagram of a generic pair of adjacent sub-selectors included in the row selector 160 according to an embodiment of the present invention. The two sub-selectors have the same circuital structure, and their elements will be discriminated by the addition of an apex for one of them (*i.e.,* SB and SB').

According to this invention embodiment, the sub-selectors SB, SB' are designed in such a way to include Medium Voltage transistors (hereinafter, MV transistors) only. For the purposes of the present description, an MV transistor is meant to be a device designed and constructed in such a way to guarantee the capability of sustaining voltage differences up-limited by a predetermined maximum voltage difference ΔVm higher than the predetermined maximum voltage difference ΔV1 that the low voltage transistors guarantee to sustain, but still lower than the predetermined maximum voltage difference ΔVh guaranteed by high voltage transistors. More particularly, in the embodiment herein considered, an MV transistor can sustain without breaking, between two terminals thereof, a voltage difference roughly equal to half the highest (in absolute value) voltage HV that the row selector has to manage. Consequently, MV MOS transistors may have gate insulators of thickness capable to avoid insulator breaking with voltage differences applied between the gate terminal and the transistor channel up to almost HV/2 (in the case of NOR memories, up to 6-7 Volts, in the case of NAND memories, up to 10-11 Volts). More particularly, MV MOS transistors adapted to sustain voltages of 6-7 Volts without causing oxide breakings may have the same gate oxide layer thickness of the memory cells, while those adapted to sustain voltages of 10-11 Volts without causing oxide breakings may have a gate oxide layer thickness equal to about 150 Angstrom.

Considering in particular the sub-selector SB (similar considerations apply to the sub-selector SB'), it includes a tree of selection MOS transistors, selectively coupling a root node Nr, adapted to receive the operative voltages Vhv from the PMU 110, to the word lines WL(i) of the corresponding packet WLP. The tree includes n selection branches BR(i), each one coupling the root node Nr to a corresponding terminal node Nt(i) by means of a nMOS selection transistor N(i) connected in series with a pMOS selection transistor P(i). Particularly, each selection transistor N(i) has a first conduction terminal. (drain/source) connected to the root node Nr and a second conduction terminal (source/drain) connected to a first conduction terminal of the selection transistor P(i). The gate terminals of the selection transistors N(i) receive respective row selection signals (denoted with Yrn(i)) from the row decoder 150. Each selection transistor P(i) has a second conduction terminal connected to the terminal node Nt(i) and a gate terminal receiving a respective selection signal Yrp(i) from the row decoder 150. Each terminal node Nt(i) is connected to a corresponding word line WL(i) of the packet WLP and to a corresponding disabling circuit branch DBR(i), whose purpose will be explained in the following of the description. Particularly, each disabling circuit branch DBR(i) includes a pair of nMOS selection transistors D1(i), D2(i) connected in series. The selection transistor D1(i) has a first conduction terminal connected to the terminal node Nt(i), a second conduction terminal connected to a first conduction terminal of the selection transistor D2(i) and a gate terminal receiving a selection signal Ycd1(i) from the row decoder 150. The selection transistor D2(i) has a gate terminal receiving a selection signal Ycd2(i) from the row decoder 150. All the selection transistors D2(i) of the sub selector SB have a second conduction terminal receiving a same erase signal ES.

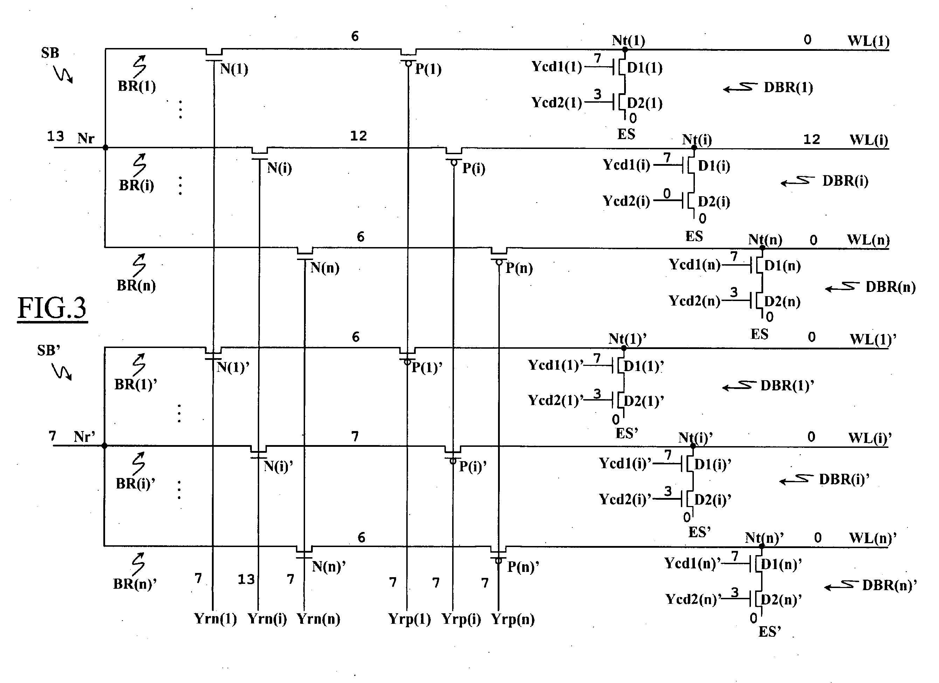

In order to describe how the sub selectors SB and SB' operate during a program, read and erase operation, reference will be now made to the Figures 3, 4 and 5. In all these Figures, it is assumed that the selected word line is the i-th word line among the n word lines of the packet WLP, *i.e.,* the word line WL(i). The remaining n-1 (unselected) word lines of the packet WLP are not depicted individually in the Figures 3, 4 and 5; instead, for the sake of clarity, only two unselected word lines are illustrate, namely the word lines WL(1) and WL(n).

In this description it is assumed that all the selection transistors, both nMOS and pMOS, have a threshold voltage of 1 Volt in absolute value. However, this value is merely illustrative, and should not be construed limitatively .

Figure 3 illustrates a program operation. As already pointed out, during a program operation, the selected word line WL(i) receives a program voltage PV equal to, for example, 12 Volts, while the unselected word lines WL(1), WL(n) receive the ground voltage GND. As will be seen in the following, the program enabling voltage PEV coincide with the highest voltage HV that the sub selector SB has to manage. Consequently, using the previous definition of MV transistors, according to the concepts of the present invention the sub-selectors SB, SB' have to be implemented with MV transistors capable to sustain voltage differences equal to HV/2=PEV/2.

The PMU 110 biases the root node of the sub block SB corresponding to a packet including a selected word line to the program enabling voltage PEV. The selection signals Yrn(i) and Yrp(i) are asserted in such a way to establish a conductive path between the root node Nr and the selected word line WL(i) (selection branch BR(i)), so as to bias the terminal node Nt(i), and thus the selected word line WL(i), to the program voltage PV (12 Volts).

For this purpose, the program enabling voltage PEV is brought to a voltage equal to or higher than the program voltage PV plus the threshold voltage of the selection transistor N(i) (for example, PEV=13 Volts; consequently, HV/2 ≈ 7 Volts), but lower than the program voltage PV plus HV/2 (*i.e.,* lower than 12+7=19 Volts). The selection signal Yrn(i) is brought to a voltage equal to the program voltage PV plus the threshold voltage of the selection transistor N(i) (13 Volts). Consequently, the voltage at the second conduction terminal of the selection transistor N(i) takes approximately the value at the gate terminal minus the threshold voltage (*i.e.,* 13-1=12 Volts). In other words, the second conduction terminal of the selection transistor N(i) assumes a voltage equal to the program voltage PV. In this way, the second conduction terminal of the selection transistor N(i) acts as a source terminal.

The selection signal Yrp(i) is instead brought to a voltage equal to or lower than the program voltage PV minus the threshold voltage but higher than the program voltage PV minus HV/2 (for example, equal to 7 Volts). In this way, the selection transistor P(i) is turned on and acts as a pass transistor, providing the voltage of its first conduction terminal (*i.e.,* the program voltage PV) to the terminal node Nt(i) and, consequently, to the selected word line WL(i).

Moreover, during the program operation the erase signal ES is brought to the ground voltage GND and the selection signal Ycd1(i), together with the corresponding selection signals in the other (unselected) disabling circuit branches (*e.g.,* the selection signals Ycd1(1) and Ycd1(n)) are brought to a voltage equal to or higher than the program voltage PV minus HV/2 and not higher than HV/2 (for example, 7 Volts). The selection signal Ycd2(i) is instead brought to the ground voltage GND, in such a way that the selection transistor D2(i) is off.

In order to bias all the other (unselected) word lines (WL(1), WL(n)) of the selected packet WLP to the ground voltage GND, the remaining selection signals are brought to different voltages, as described in the following.

More particularly, the other selection signals which bias the nMOS selection transistors (*e.g.,* the selection signals Yrn(1) and Yrn(n)) are brought to a voltage equal to or higher than the program enabling voltage PEV minus HV/2 (*i.e.,* ≥ 6 Volts), but at the same time lower than the voltage of the selection signals which bias the subsequent pMOS selection transistors in the selection branch (*e.g.,* the selection signals Yrp(1) and Yrp(n)) plus twice the threshold voltage; moreover, the selection signals Yrp(1) and Yrp(n) has to be brought to a voltage equal to or lower than HV/2. For example, all the selection signals Yrn(1), Yrn(n), Yrp(1) and Yrp(n) are biased to 7 Volts. In this way, while the selection transistors N(1) and N(n) are on, and the second conduction terminals thereof take approximately the value at the gate terminal minus the threshold voltage *(i.e.,* 6 Volts), the selection transistors P(1) and P(n) are off. However, the terminal nodes of the unselected word lines, *e.g.,* the terminal nodes Nt(1) and N(n) are not kept into a floating condition, because the selection signals Ycd2(1), Ycd2(n) are brought to 3 Volts, in such a way that the disabling circuit branches DBR(1) and DBR(n) are activated. In fact, the selecting transistors D1(1), D1(n) and D2(1), D2(n) are on, acting as pass transistors and providing the ground voltage GND to the corresponding terminal nodes Nt(1), Nt(n) and thus to the (unselected) word lines WL(1), WL(n) of the packet WLP.

Referring now to the sub-selector SB', corresponding to a packet WLP' including only non-selected word lines (*e.g.,* WL(1)', WL(i)', WL(n)'), the PMU 110 biases the root node Nr' to the program disabling voltage PDV. The program disabling voltage PDV is brought to a voltage equal to or higher than the selection signal Yrn(i) minus HV/2 but lower than the selection signal Yrp(i) plus the threshold voltage (for example, equal to 7 Volts). Moreover, the selection signals Ycd1(1)', Ycd1(i)' and Ycd1(n)' are brought to a voltage equal to or higher than the program voltage PV minus HV/2 and not higher than HV/2 (for example, 7 Volts), while the selection signals Ycd2(1)', Ycd2(i)' and Ycd2(n)' are brought to 3 Volts. In this way, all the selection branches BR(1)', BR(n)' corresponding to the selection branches BR(1), BR(n) in the sub selector SB that are associated to unselected word lines WL(1), WL(n) behave in the same way as in the sub-selector SB, with the second conduction terminal of each nMOS selection transistor N(1)', N(n)' that assumes a voltage equal to the selection signal Yrn(1), Yrn(n) minus the threshold voltage, with each pMOS selection transistor P(1)', P(i)' and P(n)' that is off and with the corresponding terminal nodes Nt(1)' Nt(i)', Nt(n)' that are biased to the ground voltage GND by means of the disabling circuit branch DBR(i).

On the other hand, the selection branch BR(i)' corresponding to the selection branch BR(i), and receiving the selection signals Yrn(i) and Yrp(i), is in a condition in which the selection transistor N(i)' acts as a pass transistors, providing the program disabling voltage PDV to the first conduction terminal of the selection transistor P(i)'. However, the latter selection transistor is off, and the corresponding terminal node Nt(i)' is brought to the ground voltage GND by means of the disabling circuit branch DBR(i).

It should be noted that with such a biasing and circuital configuration, the combined action of lowering the voltage along each non-selected selection branch BR(1)', BR(i)', BR(n)' (by means of the selection transistors N(1)' N(i)', N(n)') and of having selection transistors P(1)', P(i)', P(n)' of the pMOS type at the interface with the corresponding word lines WL(1)', WL(i)', WL(n)' allows turning off the selection transistors P(i)' in the selection branch BR(i)' corresponding to the selection branch BR(i), even when it receives the same selection signal Yrp(i) of the selection transistor P(i). This result is achieved by lowering the voltage at the first conduction terminal of the selection transistors P(i)' to a value below or at least equal to the voltage of the selection signal Yrp(i) plus the threshold voltage.

Moreover, thanks to the biasing and circuital configuration herein proposed, all the selection transistors are subjected to driving voltages (between their control terminals and conduction terminals) that are at most equal to HV/2 *(i.e.,* 7 Volts); consequently, all the selection transistors may be implemented using MV transistors (both p-channel and n-channel).

In this way, it is possible to reduce the area of the chip wherein the memory device is integrated.

Furthermore, implementing the row selector with MV transistors only (so as to use a single oxide thickness), may have a beneficial impact on the manufacturing process of the memory device.

Summarizing, the abovementioned embodiment of the present invention provides a scheme for realizing a row decoder for a NOR memory adopting a particular circuital topology, that allows using MV transistors only. In short, while the selection branch BR(i) corresponding to the selected word line WL(i) is biased in such a way that the selection transistors N(i) and P(i) are both on for establishing a conductive path connecting the root node Nr to the terminal node Nt(i), the other selection branches BR(1), BR(n), corresponding to unselected word lines WL(1), WL(n), are biased in such a way that the corresponding selection transistors P(1), P(n) are turned off, and the terminal nodes Nt(1), Nt(n) are brought to the ground voltage GND by means of the disabling circuit branches DBR(1), DBR(n).

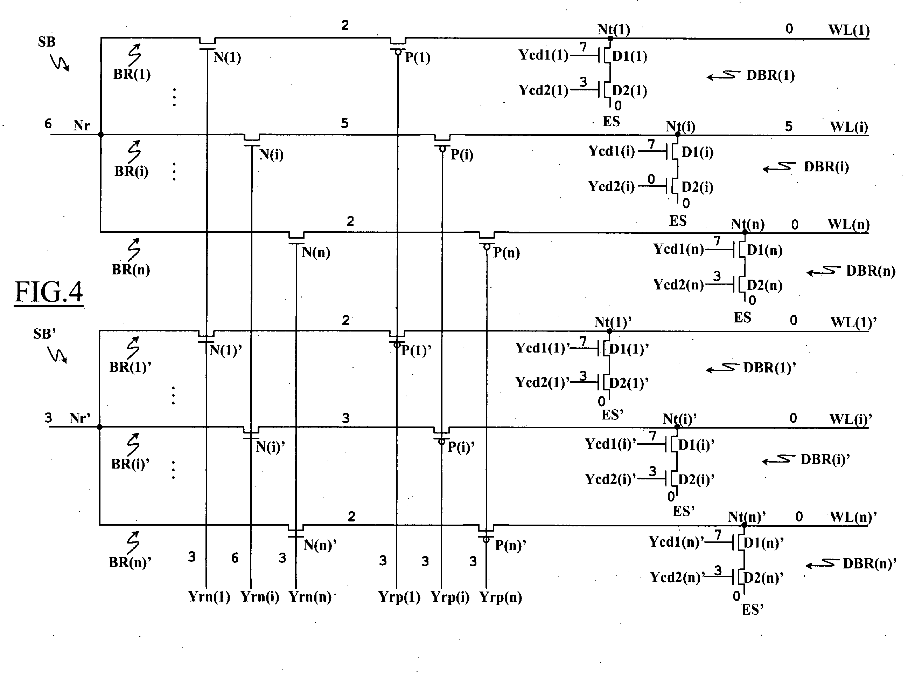

Figure 4 illustrates a read operation. As already pointed out, during a read operation, the selected word line WL(i) receives a read voltage RV equal to, for example, 5 Volts, while the unselected word lines receive the ground voltage GND. Since the sub-selectors SB, SB' operate in a way totally similar to the case of the program operation previously described, the highest voltage that the sub-selectors SB, SB' have to manage during the read operation is the reading enabling voltage REN, equal to the read voltage RV plus a threshold voltage (*i.e.,* equal to 6 Volts). Since this value is lower than the program enabling voltage PEN (13 Volts), the highest voltage HV that the sub-selector has to manage coincides again with the program enabling voltage PEV.

The PMU 110 biases the root node Nr to the read enabling voltage REN (6 Volts); moreover, the selection signal Yrn(i) is brought to a voltage equal to the read voltage RV plus the threshold voltage of the selection transistor N(i) (6 Volts), and the selection signal Yrp(i) is brought to a voltage equal to or lower than the read voltage RV minus the threshold voltage (for example, 3 Volts). In this way, the second conduction terminal of the selection transistor N(i) and the terminal node Nt(i) assume a voltage equal to the reading voltage RV (5 Volts). Moreover, during the read operation the erase signal ES is brought to the ground voltage GND, and the selection signals Ycd1(1), Ycd1(i), Ycd1(n) are brought to a voltage equal to or higher than the threshold voltage (for example, 7 Volts). The selection signal Ycd2(i) is instead brought to the ground voltage GND, in such a way that the selection transistor D2(i) is off.

In order to bias all the other (unselected) word lines WL(1), WL(n) of the packet WLP to the ground voltage GND, the remaining selection signals are brought to different voltages. Particularly, the selection signals Yrn(1), Yrn(n) are biased to a voltage lower than the selection signals Yrp(1), Yrp(n) plus twice the threshold voltage. For example, both the selection signals Yrn(1), Yrn(n) and Yrp(1), Yrp(n) are biased to 3 Volts. In this way, while the selection transistors N(1), N(n) are on, and the second conduction terminals thereof take approximately the value of the voltage at the gate terminal minus the threshold voltage (*i.e.,* 2 Volts), the selection transistors P(1), P(n) are off. The selection signals Ycd2(1) and Ycd2(n) are brought to 3 Volts, in such a way to activate both the selecting transistors D2(1) and D2(n), for providing the ground voltage GND to the corresponding terminal nodes Nt(1), Nt(n) and thus to the (unselected) word lines WL(1), WL(n) of the packet WLP.

Referring now to the sub-selector SB', the PMU 110 biases the root node Nr' to the read disabling voltage RDV. The read disabling voltage RDV is brought to a voltage lower than the selection signal Yrp(i) plus the threshold voltage (for example, equal to 3 Volts). Moreover, the selection signals Ycd1(1)', Ycd1(n)', Ycd2(1)', Ycd2(n)' are biased in the same way as the selection signals Ycd1(1), Ycd1(n), Ycd2(1), Ycd2(n).

In this way, all the selection branches BR(1)', BR(n)' corresponding to the selection branches BR(1), BR(n) in the sub-selector SB that are associated with unselected word lines WL(1), WL(n) behave in the same way as in the sub-selector SB, with the second conduction terminal of each selection transistor N(1)', N(n)' that assumes a voltage equal to the selection signal Yrn(i) minus the threshold voltage, each selection transistor P(1)', P(n)' being off and with the corresponding terminal nodes Nt(1)', Nt(n)' that are biased to the ground voltage GND by means of the disabling circuit branch DBR(1)', DBR(n)'.

On the other hand, the selection branch BR(i)' corresponding to the selection branch BR(i), and receiving the selection signals Yrn(i) and Yrp(i), is in a condition such that the selection transistor N(i)' acts as a pass transistors, providing the read disabling voltage RDV to the first conduction terminal of the selection transistor P(i)'. However, the selection transistor P(i)' is off, and the corresponding terminal node Nt(i)' is brought to the ground voltage GND by means of the disabling circuit branch DBR(i)'.

It should be noted that since the MV MOS transistors used for implementing the sub-selector SB and SB' are capable to sustain the read enabling voltage REN *(i.e.,* the highest voltage used during a read operation), the choice of the read disabling voltage and all the selection signals is simpler than in the case of the program operation, wherein the higher voltages managed by the sub-selectors (higher than HV/2) pose more restrictive constraints. For example, nothing prevents from bringing the read disabling voltage RDV and the selection signals Yrn(i) to the ground voltage GND.

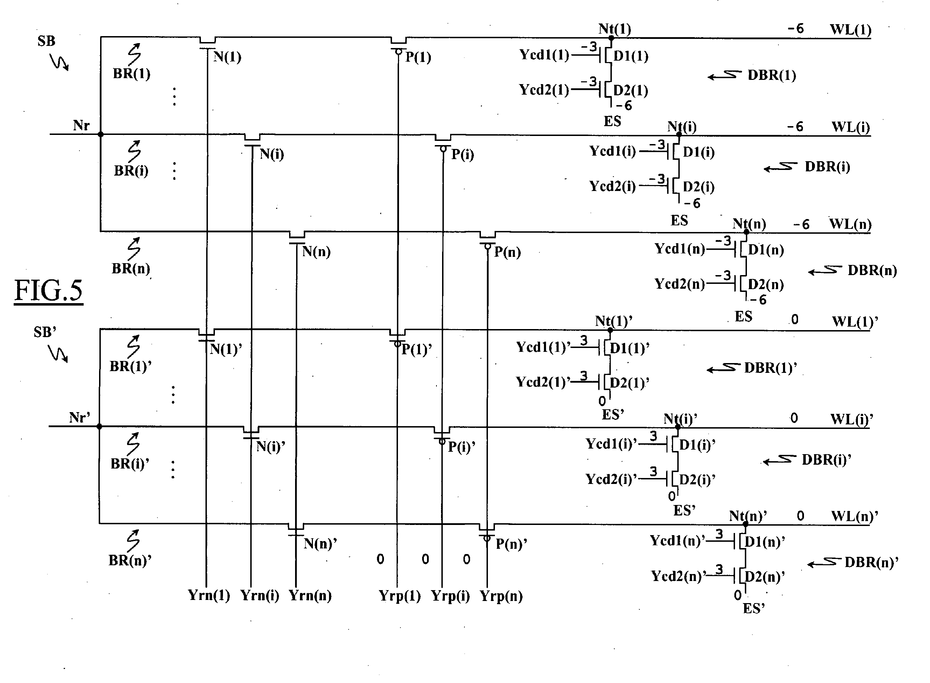

Figure 5 illustrates an erase operation. In this case, the selected word lines WL(1), WL(i), WL(n) (corresponding to all the word lines of a selected packet) receive an erase voltage EV equal to, for example, -6 Volts, while all the word lines WL(1)', WL(i)', WL(n)' of the other packets WLP receive the ground voltage GND.

The PMU 110 brings the erase signal ES (provided to the second conduction terminals of all the selection transistors D2(1), D2(i), D2(n) of the sub selector SB corresponding to the selected packet WLP) to the erase voltage EV (-6 Volts), while the erase signal ES' (provided to the second conduction terminals of all the selection transistors D2(1)', D2(i)', D2(n)' of the sub selectors SB' corresponding to the unselected packet WLP) are brought to the ground voltage GND.

Referring in particular to the sub-selector SB, all the selection signals provided to the disabling circuit branches DBR(1), DBR(i), DBR(n) are brought to a voltage equal to or higher than the erase voltage plus the threshold voltage (for example, -3 Volts), in such a way that the selection transistors of all the disabling circuit branches DBR(1), DBR(i), DBR(n) are turned on and capable of acting as pass transistors for transferring the negative erase voltage EV to the terminal nodes Nt(1), Nt(i), Nt(n) of all the selection branches BR(1), Br(i), BR(n).

Conversely, referring to the sub-selector SB', the selection signals provided to the disabling circuit branches DBR(1)', DBR(i)', DBR(n)' are brought to a voltage equal to or higher than the ground voltage GND plus the threshold voltage (for example, 3 Volts) in such a way that the selection transistors of all the disabling circuit branches DBR(1), DBR(i), DBR(n) are turned on and capable of acting as pass transistors for transferring the ground voltage GND to the terminal nodes Nt(1)', Nt(i)', Nt(n)' of all the selection branches BR(1)', Br(i)', BR(n)'.

Since both the terminal nodes Nt(1), Nt(i), Nt(n) of the sub selector SB and the terminal nodes Nt(1)', Nt(i)', Nt(n)' are directly biased by means of the disabling circuit branches, the root nodes Nr and Nr' has to be kept electrically insulated from the respective terminal nodes. For this purpose, all the selection branches of the sub-selector SB are brought to a condition in which the selection transistors P(1), P(i), P(n) are off, and all the selection branches of the sub-selector SB' are brought to a condition in which the selection transistors P(1)', P(i)', P(n)' are off. More particularly, the selection signals Yrp(1), Yrp(i), Yrp(n) are brought to a voltage equal to or higher than the ground voltage GND minus the threshold voltage but not higher than the erase voltage EV plus HV/2 (for example, to the ground voltage GND). It should be noted that, since the root nodes Nr and Nr' are kept electrically insulated from the respective terminal nodes by turning off the selection transistors P(1), P(i), P(n) and P(1)', P(i)', P(n)', it is not important whether the selection transistors N(1), N(i), N(n), N(1)', N(i)', N(n)' are turned on or off.

Although the present invention has been up to now described in detail with reference to a memory device having a NOR architecture, the concepts of the present invention are also applicable to a memory device having a NAND architecture. As those skilled in the art will appreciate, the voltage values are in this case different, being higher than in the case of the NOR architecture.

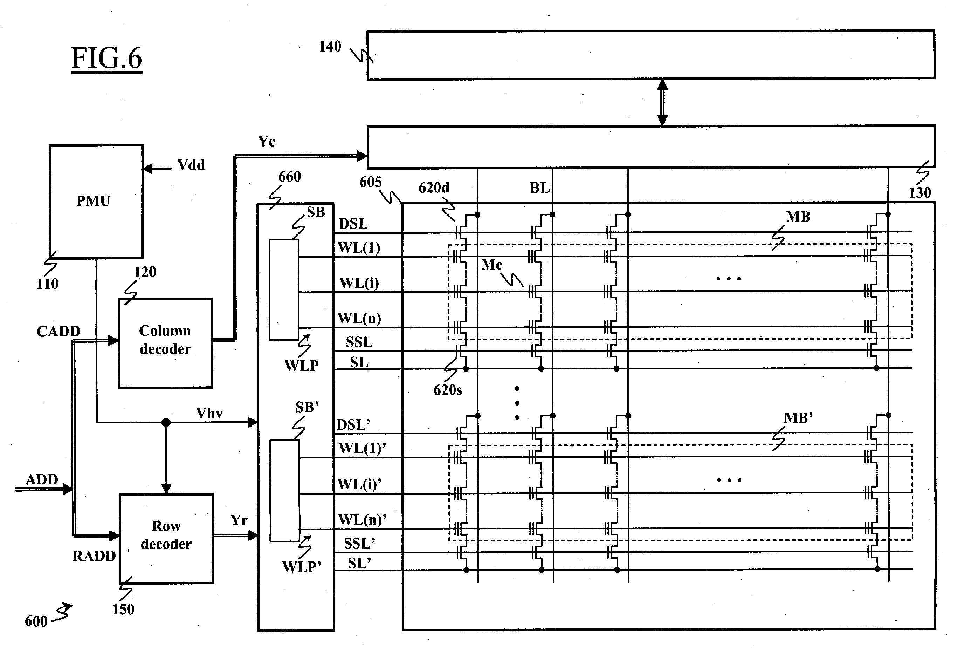

For this purpose, Figure 6 shows a non-volatile memory device 600 having a NAND architecture; the elements corresponding to those shown in Figure 1 are denoted with the same reference numerals, and their explanation is omitted for the sake of brevity.

The memory device 600 includes a matrix 605 of memory cells Mc adapted to store data, arranged in a plurality of rows and a plurality of columns. According to the NAND architecture, groups of n, *e.g.,* eight, sixteen or even more (*e.g.,* thirty-two) memory cells Mc are connected in series to each other to form a respective memory cells string, and different strings belonging to a same matrix column are connected in parallel to each other to a same bit line BL.

The n memory cells Mc of a generic string are in particular connected in series between a source select nMOS transistor 620s and a drain select nMOS transistor 620d. A generic, intermediate memory cell Mc in the string has the drain terminal connected to the source terminal of an adjacent memory cell Mc, and the source terminal connected to the drain terminal of another adjacent memory cell Mc. One of the two end memory cells Mc located at the ends of the string has the drain terminal connected to the source terminal of the drain select transistor 620d; the drain terminal of the drain select transistor 620d is connected to the corresponding bit line BL. Likewise, the other end memory cell Mc of the string has the source terminal connected to the drain terminal of the source select transistor 620s; the source terminal of the source select transistor 620s is connected to the source terminal of the corresponding source select transistor 620s of another adjacent string.

The gate terminals of the memory cells Mc in each row are connected to a corresponding word line WL(i) (i=1 to n); in this way, all the memory cells Mc belonging to a string are associated with a corresponding packet WLP of word lines WL(i). The gate terminals of the drain select transistors 620d belonging to a common row of the matrix 605 are all connected to a corresponding drain select line DSL; similarly, the gate terminals of the source select transistors 620s belonging to a common row are all connected to a corresponding source select line SSL. The drain terminals of the drain select transistors 620d belonging to a common column of the matrix 605 are connected to a corresponding bit line BL. Conversely, the source terminals of all the source select transistors 620s in the matrix 605 are connected to a common source line SL (which is typically kept at the ground voltage GND).

Also in this case the memory cells Mc are grouped in memory blocks MB: more particularly, a memory block MB is formed by the memory cells Mc connected to the word lines WL(i) of a corresponding packet WLP. In the matrix 605 of Figure 6 two memory blocks are shown (denoted MB and MB').

The operative voltages Vhv generated by the PMU 110 that are used for performing the conventional operations (such as read, program, erase and verify) on the memory device 600 range for example from -6 Volts to 20 Volts. It should be noted that a NAND memory cell, in order to be programmed, requires to be biased with voltages that are higher (in absolute value) than the voltages used for programming a NOR memory cell.

The selection of the desired bit lines BL is carried out in the same way as for the memory device 100.

Regarding the selection of the desired word line WL(i), the row decoder 150 receives the row address RADD, and accordingly generates a plurality of row selection signals Yr. The row selection signals Yr are provided to a row selector 660, which enables a single word line WL(i). The row selector 660 has a modular structure, comprising a sub-selector SB for each packet WLP. While in the NOR case all the sub-selectors SB of the row selector 160 receive the same selection signals Yr, in the NAND case each sub-selector SB of the row selector 660 receive dedicated selection signals, as will be more clear in the following of the present description.

During a program operation, the selected memory cells Mc that need to be programmed receive the program voltage PV (for example, 19 Volts) at their gate terminals, while the drain selector transistors 620d in the strings to which the cells to be programmed belong has to be turned on and the source select transistor 620s has to be turned off. For this purpose, the corresponding drain select line DSL is asserted (for example, bringing this line to the supply voltage Vdd), whereas the source select line SSL is deasserted (*e.g.,* grounded). Moreover, the PMU 110 provides the program enabling voltage PEV (for example, 20 Volts) and the program disabling voltage PDV (for example, the ground voltage GND) to the row selector 660. The program enabling voltage PEV is then provided to the sub-selector SB corresponding to the packet WLP comprising the selected word line WL(i), while the others sub-selectors receive instead the program disabling voltage PDV. The sub-selector SB that receives the program enabling voltage PEV biases in turn the selected word line WL(i) at the program voltage PV and the remaining word lines WL(i) controlling the gates of the other memory cells of the same string (*i.e.,* the other word lines WL(i) of the packet WLP) at a potential relatively high (*e.g.,* approximately 10 V), but sufficiently lower than the program voltage PV, not to cause spurious programming. Conversely, the remaining sub-selectors SB, *i.e.,* those sub-selectors (associated with different strings) that have received the program disabling voltage PDV, bias all the word lines WL(i) of their corresponding packet WLP to the ground voltage GND.

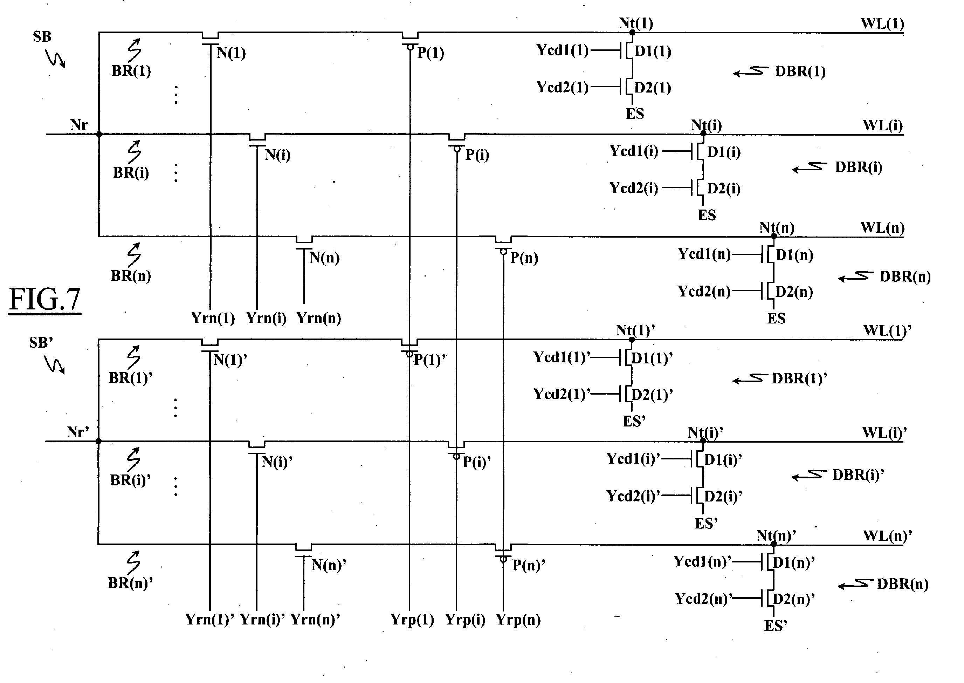

Figure 7 illustrates a circuit diagram of a generic pair of adjacent sub-selectors (SB and SB') included in the row selector 660, according to an embodiment of the present invention. The two sub-selectors SB and SB' have the same circuital structure of the sub-selectors of the embodiment illustrated in Figure 2, so the explanation of their elements is omitted. Moreover, the sub-selectors SB, SB' are designed in such a way to include MV transistors only. The only difference between the sub-selectors of the two embodiments is that in the embodiment illustrated in Figure 7 (adapted to be employed in NAND memory devices) different sub-selectors SB, SB' receive different row selection signals Yrn(i), Yrn(i)', while in the embodiment of Figure 2 (adapted to be employed in NOR memory devices) all the sub-selectors SB, SB' receive the same selection signals Yrn(i). However, it should be noted that in Figure 7 the selection signals Yrp(i), *i.e.,* those biasing the pMOS selection transistors, are again the same for all the sub-selectors SB, SB', as in the case of the embodiment of Figure 2.

The necessity of differentiating the selection signals Yrn(i), Yrn(i)' for each sub-selector SB, SB' of the row selector 660 is due to the particular biasing scheme that a string of memory cells Mc arranged according to a NAND architecture requires. In fact, while in the NOR case the unselected word lines WL(i) belonging to the packet WLP including the selected word line WL(i) can be biased in the same way as the word lines WL(i) belonging to the other (unselected) packets WLP, in the NAND case the unselected word lines WL(i) belonging to the packet including the selected word line WL(i) has to be biased to a relatively high pass voltage PASSV such as to render conductive the corresponding memory cells Mc (for example, the pass voltage PASSV may be equal to 10 Volts). Consequently, each sub-selector SB, SB' has to be capable of being selectively biased by means of dedicated selection signals.

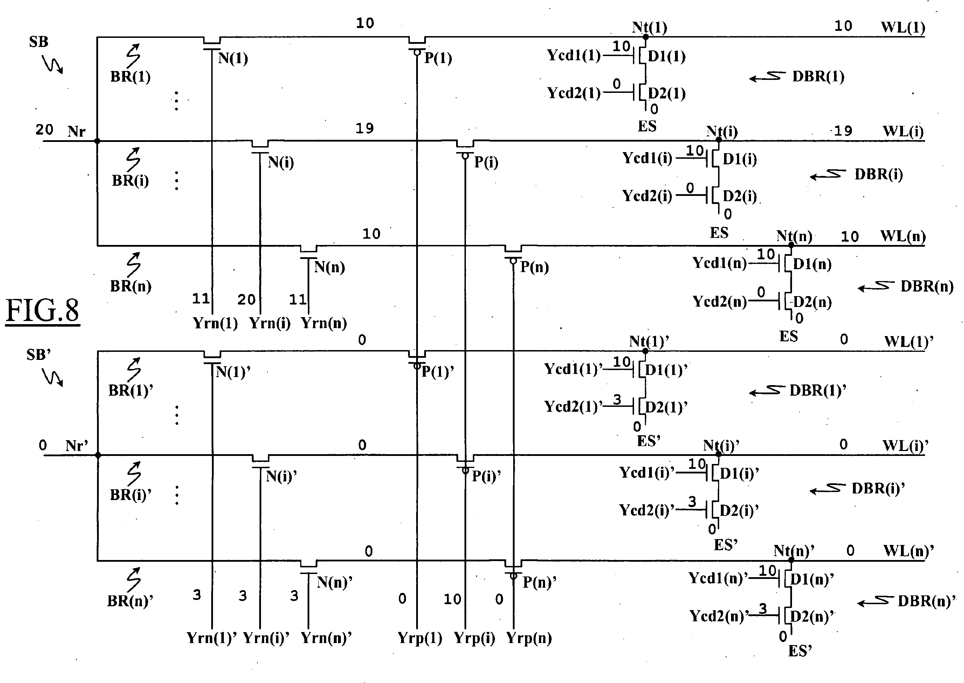

In order to describe how the sub-selectors SB and SB' of Figure 7 operate during a program operation, reference will be now made to Figure 8. For the sake of conciseness, the case of the read operation is not described, being similar to the case of the program operation. Moreover, for performing an erase operation the word lines WL(i) of a NAND memory device need only low (in absolute value) biasing voltages (e.g. 3 Volts and the ground voltage GND). In fact, as known to those skilled in the art, the semiconductor well including all the memory cells Mc of the matrix 605 is usually already biased at a high bulk erase voltage (*e.g.,* 20 Volts). Consequently, also the erase operation will not be described, because not relevant to the scope of the present invention.

Figure 8 illustrates a program operation. As will be seen in the following, the program enabling voltage PEV (20 Volts) will coincide with the highest voltage HV that the sub-selector SB will manage. Consequently, with the definition of MV transistors previously stated in the present description, according to the concepts of the present invention the sub-selectors SB, SB' have to be implemented with MV transistors capable to sustain voltage differences equal to HV/2=PEV/2.

The PMU 110 biases the root node of the sub block SB corresponding to a packet including a selected word line at the program enabling voltage PEV. The selection signals Yrn(i) and Yrp(i) are asserted in such a way as to establish a conductive path between the root node Nr and the selected word line WL(i) (selection branch BR(i)), so as to bias the terminal node Nt(i), and thus the selected word line WL(i), at the program voltage PV (*e.g.,* 19 Volts).

For this purpose, the program enabling voltage PEV is brought to a voltage equal to or higher than the program voltage PV plus the threshold voltage of the selection transistor N(i) (for example, PEV=20 Volts and HV/2 ≈ 10 Volts), but lower than the program voltage PV plus HV/2 (*i.e.,* lower than 19+10=29 Volts). The selection signal Yrn(i) is brought to a voltage equal to the program voltage PV plus the threshold voltage of the selection transistor N(i) (20 Volts). Consequently, the voltage at the second conduction terminal of the selection transistor N(i) tries to take approximately the value at the gate terminal minus the threshold voltage (*i.e.,* 20-1=19 Volts). In other words, the second conduction terminal of the selection transistor N(i) assumes a voltage equal to the program voltage PV. In this way, the second conduction terminal of the selection transistor N(i) acts as a source terminal.

The selection signal Yrp(i) is instead brought to a voltage equal to or lower than the program voltage PV minus the threshold voltage but higher than the program voltage PV minus HV/2 (for example, equal to 10 Volts). In this way, the selection transistor P(i) is turned on and acts as a pass transistor, transferring the voltage present at its first conduction terminal (*i.e.,* the program voltage PV) to the terminal node Nt(i) and, consequently, to the selected word line WL(i).

Moreover, during the program operation the erase signal ES (as well as the erase signal ES' provided to the other sub-selectors SB') is brought to the ground voltage GND and the selection signal Ycd1(i), together with the corresponding selection signals in the other (unselected) disabling circuit branches (*e.g.,* the selection signals Ycd1(1) and Ycd1(n)) are brought to a voltage equal to or higher than the program voltage PV minus HV/2 and not higher than HV/2 (for example, 10 Volts), while the selection signals Ycd2(1), Ycd2(i), Ycd2(n) are instead brought to the ground voltage GND, in such a way that the selection transistors D2(1), D2(i), D2(n) are off.

In order to bias all the other (unselected) word lines (WL(1), WL(n)) of the selected packet WLP to the pass voltage PASSV, the remaining selection signals Yrn(1), Yrn(n) provided to the sub-selector SB are brought to different voltages as described in the following.

More particularly, the other selection signals which bias the nMOS selection transistors (*e.g.,* the selection signals Yrn(1) and Yrn(n)) are biased at a voltage equal to or higher than the program enabling voltage PEV minus HV/2 *(i.e., ≥* 10 Volts), but at the same time lower than the selection signals which bias the subsequent pMOS selection transistors in the selection branch (*i.e.,* the selection signals Yrp(1) and Yrp(n)) plus twice the threshold voltage; moreover, the selection signals Yrp(1) and Yrp(n) has to be brought to a voltage equal to or lower than HV/2.

For example, both the selection signals Yrn(1) and Yrn(n) are brought to 11 Volts, and both the selection signals Yrp(1) and Yrp(n) are brought to the ground voltage GND. In this way, the voltages at the second conduction terminals of the selection transistors N(1) and N(n) try to take approximately the value at the gate terminal minus the threshold voltage *(i.e.,* 11-1=10 Volts). In other words, the second conduction terminals of the selection transistors N(1) and N(n) assume a voltage equal to the pass voltage PASSV. Since the selection transistors P(1) and P(n) are both on, the terminal nodes of the other word lines of the packet, *e.g.,* the terminal nodes Nt(1) and N(n), are biased to the pass voltage PASSV.

Referring now to the sub selector SB', corresponding to a packet WLP' including only non-selected word line (*e.g.,* WL(1)', WL(i)', WL(n)'), the PMU 110 biases the root node Nr' to the program disabling voltage PDV. Since the selection signals Yrn(1)', Yrn(i)', Yrn(n)' provided to the sub-selector SB' are different from the selection signals Yrn(1), Yrn(i), Yrn(n) biasing the nMOS selection transistors of the sub-selector SB, it is not necessary to respect particular constraints for choosing their voltage values, except that such voltage values shall be lower than HV/2. For example, the program disabling voltage PDV is brought to the ground voltage GND, and the selection signals Yrn(1)', Yrn(i)', Yrn(n)' to a voltage of 3 Volts. In this way, all the selection transistors N(1)', N(i)' and N(n)' are turned on, acting as pass transistors. However, the selection transistors P(1)', P(i)' and P(n)' are off, receiving the same selection signals Yrp(1), Yrp(i), Yrp(n) of the sub-selector SB. The selection signals Ycd1(1)', Ycd1(i)' and Ycd1(n)' are brought to the same voltage of the selection signals Ycd1(1), Ycd1(i) and Ycd1(n) *(i.e.,* to 10 Volts), while the selection signals Ycd2(1)', Ycd2(i)' and Ycd2(n)' are brought to 3 Volts. In this way, all the selection branches BR(1)', BR(i)', BR(n)' associated to unselected word lines WL(1)', WL(i)', WL(n) have their corresponding terminal nodes Nt(1)' Nt(i)', Nt(n)' that are biased to the ground voltage GND by means of the disabling circuit branches DBR(1)', DBR(i)', DBR(n)'.

Thanks to the biasing and circuital configuration herein proposed, all the selection transistors are subjected to driving voltages (between their control terminals and conduction terminals) that are at most equal to HV/2 *(i.e.,* 10 Volts); consequently, all the selection transistors may be implemented using MV transistors (both p-channel and n-channel).

Summarizing, the abovementioned embodiment of the present invention provides a scheme for realizing a row decoder for a NAND memory adopting a particular circuital topology, that allows using MV transistors only. In short, while the terminal nodes Nt(1)' Nt(i)', Nt(n)' in the unselected sub-selectors SB' are brought to the ground voltage GND by means of the disabling circuit branches DBR(1)', DBR(i)', DBR(n)', the terminal nodes Nt(1), Nt(i), Nt(n) in the sub-selector SB are biased to a voltage equal to a fraction of the program enabling voltage PEV (received at the root node Nr), said fraction being obtained through a voltage lowering action performed by the nMOS selection transistors N(1), N(i), N(n).

Naturally, in order to satisfy local and specific requirements, a person skilled in the art may apply to the solution described above many modifications and alterations. Particularly, although the present invention has been described in detail with reference to preferred embodiment(s) thereof, it should be understood that various omissions, substitutions and changes in the form and details as well as other embodiments are possible; moreover, it is expressly intended that specific elements described in connection with any of the disclosed embodiment of the invention may be incorporated in any other embodiment as a general matter of design choice.

## Claims

1. A non-volatile memory device, including:
a memory matrix (105; 605) comprising a plurality of memory cells (Mc), arranged according to a plurality of rows and a plurality of columns;
a plurality of word lines (WL(i)), each word line being associated with one respective row of said plurality and being connected to the memory cells of the row, the word lines being grouped into at least one packet (WLP);
a row selector (160; 660) coupled to the word lines and adapted to selectively biasing them, the row selector including, for each packet of word lines, a plurality of first paths, each first path being adapted to apply a first biasing voltage to a corresponding word line of the packet depending on an operation to be performed on the memory cells connected to the corresponding word line, each first path including a first selection transistor (N(i)) series-connected between a first terminal (N_{T}) and a second terminator (Nt(i)) of first path:
enabling means (110) for commonly providing an enabling voltage (Vhv) to the first terminal (N_{T}) of the first paths associated to a selected packet of word lines including a selected word line, said enabling voltage depending on the operation to be performed on the memory cells connected to the selected word line and being adapted to enable the execution of said operation;
selection means (150) for selecting one among said plurality of first paths, the selected first path corresponding to the selected word line, the selection means being adapted to activate the first selection transistor (N(i)) of the selected first path in order to obtain the first biasing voltage from the enabling voltage by a voltage drop introduced by the first selection transistor,
**characterised in that**
each first path includes a second selection transistor (P(i)) series-connected with the first selection transistor (N(i)) between said first terminal and a second terminal of said first path;
said second terminal is coupled to the corresponding word line, and that;
said selection means is further adapted to activate said second selection transistor (P(i)) in order to transfer the first biasing voltage provided by the first selection transistor (N(i)) onto the selected word line.

2. The non-volatile memory device according to claim 1, wherein the selection means are adapted to turn off the second selection transistors of the first paths associated to the non-selected packets of word lines so as to electrically insulate the first terminal of each first path associated with the non-selected packets of word lines from the corresponding second terminal.

3. The non-volatile memory device according to claim 2, wherein the selection means are adapted to generate a plurality of first selection signals, each first selection signal controlling a respective second selection transistor in the plurality of first paths associated with each word line packet.

4. The non-volatile memory device according to claim 3, further including a plurality of second paths, each second path being coupled to the second terminal of a corresponding first path and being adapted to selectively apply a second biasing voltage to the corresponding word line.

5. The non-volatile memory device according to claim 4, wherein the selection means are adapted to generate a plurality of second selection signals, each second selection signal controlling a respective first selection transistor in the plurality of first paths associated with each word line packet.

6. The non-volatile memory device according to claim 5, wherein the selection means are adapted to turn off the second selection transistors of the non-selected first paths associated with the selected packet of word lines so as to electrically insulate the first terminal of each non-selected first path associated with the selected packet of word lines from the corresponding second terminal.

7. The non-volatile memory device according to claim 6, wherein the memory matrix has a NOR architecture, the first biasing voltage is a program voltage or a read voltage and the second biasing voltage is an erasing voltage or a program and read-inhibit voltage.

8. The non-volatile memory device according to claim 4, wherein the selection means are adapted to generate second selection signals for controlling the first selection transistor of a each first path, said second selection signals being differentiated for each word lines packet.

9. The non-volatile memory device according to claim 8, wherein the selection means are adapted to activate the first selection transistors of the non-selected first paths associated with the selected packet of word lines so as to obtain a third biasing voltage from the enabling voltage by a voltage drop introduced by the first selection transistors.

10. The non-volatile memory device according to claim 9, wherein the selection means are adapted to activate the second selection transistors of the non-selected first paths associated with the selected packet of word lines so as to transfer the third biasing voltage to the corresponding word lines.

11. The non-volatile memory device according to claim 10, wherein the memory matrix has a NAND architecture, the first biasing voltage is a program voltage, the second biasing voltage is an erasing voltage or a program and read inhibit voltage and the third biasing voltage is a pass voltage adapted to turn the memory cells on and inhibiting programming thereof.

12. The non-volatile memory device according to any one of the preceding claims, wherein each first and second selection transistor is adapted to guarantee the capability of sustaining voltage differences across terminals thereof that are up-limited in absolute value by half the enabling voltage.

## Patentansprüche

1. Nichtflüchtiges Speicherbauelement, das Folgendes umfasst:
eine Speichermatrix (105; 605) mit mehreren Speicherzellen (Mc), die in mehreren Reihen und mehreren Spalten angeordnet sind;
mehrere Wortleitungen (WL(i)), wobei jede Wortleitung mit einer jeweiligen Reihe der genannten Mehrzahl assoziiert und mit den Speicherzellen der Reihe verbunden ist, wobei die Wortleitungen zu wenigstens einem Paket (WLP) gruppiert sind;
einen Reihenselektor (160; 660), der mit den Wortleitungen gekoppelt und so gestaltet ist, dass er sie selektiv vorspannt, wobei der Reihenselektor für jedes Wortfeitungspaket mehrere erste Pfade beinhaltet, wobei jeder erste Pfad die Aufgabe hat, eine erste Vorspannung an eine entsprechende Wortleitung des Pakets je nach einer Operation anzulegen, die an den mit der entsprechenden Wortleitung verbundenen Speicherzellen ausgeführt werden soll, wobei jeder erste Pfad einen ersten Selektionstransistor (N(i)) aufweist, der in Serie zwischen einem ersten Anschluss (N_{T}) und einem zweiten Anschluss (Nt(i)) des ersten Pfades in Serie geschaltet ist;
ein Freigabemittel (110) zum gemeinsamen Anlegen einer Freigabespannung (Vhv) an den ersten Anschluss (N_{T}) der ersten Pfade, die mit einem selektierten Wortleitungspaket einschließlich einer selektierten Wortleitung assoziiert sind, wobei die genannte Freigabespannung von der Operation abhängig ist, die an den mit der selektierten Wortleitung verbundenen Speicherzellen ausgeführt werden soll, und die Aufgabe hat, die Ausführung der genannten Operation zu ermöglichen;
ein Selektionsmittel (150) zum Selektieren eines der genannten mehreren ersten Pfade, wobei der selektierte erste Pfad der selektierten Fortleitung entspricht, wobei das Selektionsmittel die Aufgabe hat, den ersten Selektionstransistor (N(i)) des selektierten ersten Pfades zu aktivieren, um die erste Vorspannung von der Freigabespannung durch einen vom ersten Selektionstransistor bewirkten Spannungsabfall zu erhalten;
**dadurch gekennzeichnet, dass**
jeder erste Pfad einen zweiten Selektionstransistor (P(i)) aufweist, der in Serie mit dem ersten Selectionstransistor (N(i)) zwischen dem genannten ersten Anschluss und einem zweiten Anschluss des genannten ersten Pfades geschattet ist;
wobei der genannte zweite Anschluss mit der entsprechenden Wortleitung gekoppelt ist, und **dadurch**, dass
das genannte Selektionsmittel ferner die Aufgabe hat, den genannten zweiten Selektionstransistor (P(i)) zu aktivieren, um die vom ersten Selektionstransistor (N(i)) erzeugt erste Vorspannung auf die selektierte Fortleitung zu übertragen.

2. Nichtflüchtiges Speicherbauelement nach Anspruch 1, wobei die Selektionsmittel die Aufgabe haben, die zweiten Selektionstransistoren der ersten mit den nichtsclektierten Wortleitungspaketen assoziierten Pfade abzuschalten, um den ersten Anschluss jedes mit den nichtseiektierten Wortleitungspaketen assoziierten ersten Pfades von dem entsprechenden zweiten Anschluss elektrisch zu isolieren.

3. Nichtflüchtiges Speicherbauelement nach Anspruch 2, wobei die Selektionsmittel die Aufgabe haben, eine Mehrzahl von ersten Selektionssignalen zu erzeugen, wobei jedes erste Selektionssignal einen jeweiligen zweiten Setektionstransistor der mehreren mit jedem Wortleitungspaket assoziierten ersten Pfade steuert.

4. Nichtflüchtiges Speicherbauelement nach Anspruch 3, das ferner mehrere zweite Pfade aufweist, wobei jeder zweite Pfad mit dem zweiten Anschluss eines entsprechenden ersten Pfades gekoppelt ist und die Aufgabe hat, eine zweite Vorspannung selektiv an die entsprechende Wortleitung anzulegen.

5. Nichtflüchtiges Speicherbauelement nach Anspruch 4, wobei die Selektionsmittel die Aufgabe haben, mehrere zweite Selektionssignale zu erzeugen, wobei jedes zweite Selektionssignal einen jeweiligen ersten Sclektionstransistor der mehreren mit jedem Wortteitungspaket assoziierten ersten Pfade steuert.

6. Nichtflüchtiges Speicherbauelement nach Anspruch 5, wobei die Selektionsmittel die Aufgabe halben, die zweiten Selektionstransistoren der mit dem selektierten Wortleitungspaket assoziierten nichtselektierten ersten Pfade abzuschalten, um den ersten Anschluss jedes mit dem selektierten Wortleitungspaket assoziierten nichtsctektierten ersten Pfades vom entsprechenden zweiten Anschluss elektrisch zu isolieren.

7. Nichtflüchtiges Speicherbauelement nach Anspruch 6, wobei die Speichermatrix eine NOR-Architektur hat, die erste Vorspannung eine Programmierspannung oder eine Lesespannung ist und die zweite Vorspannung eines Löschspannung oder eine Programmier- und Lesesperrspannung ist.

8. Nichtflüchtiges Speicherbauclement nach Anspruch 4, wobei die Selektionsmittel die Aufgabe haben, zweite Selektionssignale zum Steuern des ersten Selektionstransistors jedes ersten Pfades zu erzeugen, wobei die genannten zweiten Selektionssignale für jedes Wortleitungspaket differenziert werden.

9. Nichtflüchtiges Speicherbauelement nach Anspruch 8, wobei die Selektionsmittel die Aufgabe haben, die ersten Selektionstransistoren der mit dem selektierten Wortleitungspaket assoziierten nichtselektierten ersten Pfade zu aktivieren, um eine dritte Vorspannung von der Freigabespannung durch einen von den ersten Sefektionstransistoren bewirkten Spannungsabfall zu erhaben.

10. Nichtflüchtiges Speicherbauelement nach Anspruch 9, wobei die Selektionsmittel die Aufgabe haben, die zweiten Selektionstransistoren der mit dem selektierten Wortfeitungspaket assoziierten nichtselektierten ersten Pfade zu aktivieren, um die dritte Verspannung auf die entsprechenden Wortleitungen zu übertragen.

11. Nichtflüchtiges Speicherbauelement nach Anspruch 10, wobei die Speichermatrix eine NAND-Architektur hat, die erste Vorspannung eine Programmierspannung ist, die zweite Vorspannung eine Löschspannung oder eine Programmier- und Lesesperrspannung ist und die dritte Vorspannung eine Durchgangsspannung ist mit der Aufgabe, die Speicherzellen einzuschalten und deren Programmierung zu sperren.

12. Nichtflüchtiges Speicherbauelement nach einem der vorherigen Ansprüche, wobei jeder erste und zweite Selektionstransistor die Aufgabe hat, die Fähigkeit des Aushaltens von Spannungsdifferenzen über Anschlüsse davon zu garantieren, deren absoluter Wert durch die Hälfte der Freigabespannung nach oben begrenzt ist.

## Revendications

1. Un dispositif à mémoire non volatile, comprenant:
une matrice de mémoire (105; 106) comprenant une pluralité de cellules mémoire (Mc) agencées selon une pluralité de lignes et une pluralité de colonnes,
une pluralité de lignes de mots (WL(i)), chaque ligne de mots étant associée à une ligne respective de ladite pluralité et étant connectée aux cellules mémoire de la ligne, les lignes de mots étant groupées en au moins un paquet (WLP),
un sélecteur de lignes (160; 660) couplé aux lignes de mots et adapté de façon à les polariser de manière sélective, le sélecteur de lignes comprenant, pour chaque paquet de lignes de mots, une pluralité de premiers chemins, chaque premier chemin étant adapté de façon à appliquer une première tension de polarisation à une ligne de mots correspondante du paquet en fonction d'une opération à exécuter sur les cellules mémoire connectées à la ligne de mots correspondante, chaque premier chemin comprenant un premier transistor de sélection (N(i)) connecté en série entre une première borne (N_{T}) et une deuxième borne (Nt(i) du premier chemin,
un moyen d'activation (110) destiné à fournir de manière commune une tension d'activation (Vhv) à la première borne (N_{T}) des premiers chemins associés à un paquet sélectionné de lignes de mots comprenant une ligne de mots sélectionnée, ladite tension d'activation dépendant de l'opération à exécuter sur les cellules mémoire connectées à la ligne de mots sélectionnée et étant adaptée de façon à activer l'exécution de ladite opération,
un moyen de sélection (150) destiné à sélectionner une chemin parmi ladite pluralité de premiers chemins, le premier chemin sélectionné correspondant à la ligne de mots sélectionnée, le moyen de sélection étant adapté de façon à activer le premier transistor de sélection (N(i)) du premier chemin sélectionné afin d'obtenir la première tension de polarisation de la tension d'activation par une chute de tension introduite par le premier transistor de sélection,
**caractérisé en ce que**
chaque premier chemin comprend un deuxième transistor de sélection (P(i)) connecté en série au premier transistor de sélection (N(i)) entre ladite première borne et une deuxième borne dudit premier chemin,
ladite deuxième borne est couplée à ladite ligne de mots correspondante, et **en ce que**
ledit moyen de sélection est adapté en outre de façon à activer le deuxième transistor de sélection (P(i)) de façon à transférer la première tension de polarisation fournie par le premier transistor de sélection (N(i)) vers la ligne de mots sélectionnée.

2. Le dispositif à mémoire non volatile selon la Revendication 1, où le moyen de sélection est adapté de façon à désactiver les deuxièmes transistors de sélection des premiers chemins associés aux paquets non sélectionnés de lignes de mots de façon à isoler électriquement la première borne de chaque premier chemin associé aux paquets non sélectionnés de lignes de mots de la deuxième borne correspondante.

3. Le dispositif à mémoire non volatile selon la Revendication 2, où le moyen de sélection est adapté de façon à générer une pluralité de premiers signaux de sélection, chaque premier signal de sélection commandant un deuxième transistor de sélection respectif dans la pluralité de premiers chemins associés à chaque paquet de ligne de mots.

4. Le dispositif à mémoire non volatile selon la Revendication 3, comprenant en outre une pluralité de deuxième chemins, chaque deuxième chemin étant couplé à la deuxième borne d'un premier chemin correspondant et étant adapté de façon à appliquer de manière sélective une deuxième tension de polarisation à la ligne de mots correspondante.

5. Le dispositif à mémoire non volatile selon la Revendication 4, où le moyen de sélection est adapté de façon à générer une pluralité de deuxièmes signaux de sélection, chaque deuxième signal de sélection commandant un premier transistor de sélection respectif dans la pluralité de premiers chemins associés à chaque paquet de ligne de mots.

6. Le dispositif à mémoire non volatile selon la Revendication 5, où le moyen de sélection est adapté de façon à désactiver les deuxièmes transistors de sélection des premiers chemins non sélectionnés associés au paquet sélectionné de lignes de mots de façon à isoler électriquement la première borne de chaque premier chemin non sélectionné associé au paquet sélectionné de lignes de mots de la deuxième borne correspondante.

7. Le dispositif à mémoire non volatile selon la Revendication 6, où la matrice de mémoire possède une architecture NON-OU, la première tension de polarisation est une tension de programme ou une tension de lecture et la deuxième tension de polarisation est une tension d'effacement ou une tension de programme et de blocage de lecture.

8. Le dispositif à mémoire non volatile selon la Revendication 4, où le moyen de sélection est adapté de façon à générer des deuxièmes signaux de sélection destinés à commander le premier transistor de sélection de chaque premier chemin, lesdits deuxièmes signaux de sélection étant différenciés pour chaque paquet de lignes de mots.

9. Le dispositif à mémoire non volatile selon la Revendication 8, où le moyen de sélection est adapté de façon à activer les premiers transistors de sélection des premiers chemins non sélectionnés associés au paquet sélectionné de lignes de mots de façon à obtenir une troisième tension de polarisation de la tension d'activation par une chute de tension introduite par les premiers transistors de sélection.

10. Le dispositif à mémoire non volatile selon la Revendication 9, où le moyen de sélection est adapté de façon à activer les deuxièmes transistors de sélection des premiers chemins non sélectionnés associés au paquet sélectionné de lignes de mots de façon à transférer la troisième tension de polarisation vers les lignes de mots correspondantes.

11. Le dispositif à mémoire non volatile selon la Revendication 10, où la matrice de mémoire possède une architecture NON-ET, la première tension de polarisation est une tension de programme, la deuxième tension de polarisation est une tension d'effacement ou une tension de programme et de blocage de lecture et la troisième tension de polarisation est une tension de passage adaptée de façon à activer les cellules mémoire et à inhiber leur programmation.

12. Le dispositif à mémoire non volatile selon l'une quelconque des Revendications précédentes où chaque premier et deuxième transistor de sélection est adapté de façon à garantir la capacité de maintenir des différences de tension sur des bornes de ceux-ci qui sont limitées vers le haut en valeur absolue de la moitié de la tension d'activation.
